# FASCICULE DE BREVET EUROPEEN

(11) **EP 4 551 953 B1**
(45) Date de publication et mention de la délivrance du brevet: **09.09.2026**
(21) Numéro de dépôt: 23744365.0
(22) Date de dépôt: 05.07.2023
(51) Int. Cl.: G01R 31/12, G01R 31/16

(54) **DISPOSITIF DE DÉTECTION ACOUSTIQUE D'UN ARC ÉLECTRIQUE**
VORRICHTUNG ZUR AKUSTISCHEN ERFASSUNG EINES LICHTBOGENS
DEVICE FOR ACOUSTIC DETECTION OF AN ELECTRIC ARC

(30) Priorité: 05.07.2022 FR 2206853
(43) Date de publication de la demande: 14.05.2025
(73) Titulaire: Office National d'Etudes et de Recherches Aérospatiales, 91120 Palaiseau (FR)
(72) Inventeur: SIMON, Frank, 91120 PALAISEAU (FR); SEBBANE, Delphine, 91120 PALAISEAU (FR)
(74) Mandataire: Hautier IP
(86) Numéro de dépôt international: PCT/EP2023/068589
(87) Numéro de publication internationale: WO 2024/008811

(56) Documents cités:
- EP-A1- 3 492 934
- ES-A1- 2 301 406
- US-A1- 2012 105 073
- US-B2- 10 534 031

## Description

### Domaine technique

Le domaine de l'invention est celui des équipements électriques, en particulier des câbles, au niveau desquels peuvent naitre des arcs électriques.

L'invention concerne plus particulièrement une technique de détection acoustique d'un arc électrique.

### Arrière-plan

Dans de nombreuses industries et, notamment, dans l'industrie aéronautique, le câblage électrique est un équipement critique des systèmes électriques. Divers phénomènes comme l'apparition d'une fragilité dans un câble au fil du temps, un défaut de fabrication d'un câble, un problème de montage ou encore une surcharge de tension d'un élément extérieur au câble, peuvent conduire à la formation d'un arc électrique au niveau du câble. L'arc électrique peut, à son tour, être la source d'une fragilisation, d'un endommagement durable ou de perturbations (électriques ou électromagnétiques) du système électrique.

Afin de pouvoir intervenir au plus vite, les industriels recherchent des techniques pour détecter l'apparition des arcs électriques.

Les techniques de détection d'arcs basées sur des mesures de courant et de tension sont les plus courantes. Ces techniques se heurtent cependant à la complexité des câblages (trop grand nombre de câbles, incertitude sur les routages, etc.). Ceci conduit à rechercher des techniques de détection alternatives ou complémentaires.

Les documents de brevet EP 3232212, EP 2896969 et EP 3264116 décrivent des dispositifs de détection d'arcs électrique dans une installation électrique, basés sur la détection de l'onde acoustique qui se manifeste en présence d'un arc électrique. Ces dispositifs sont placés au plus près de l'arc électrique éventuel (au contact de cosses électriques ou dans des modules électriques de l'installation) pour détecter l'apparition d'un arc électrique à leur emplacement. Ces dispositifs se révèlent donc inadaptés pour détecter sur une grande distance et, en particulier, le long d'un câble électrique de plusieurs mètres ou dizaines de mètres, l'apparition d'un arc électrique. Ces dispositifs permettent encore moins de localiser l'endroit, le long du câble électrique, où l'arc électrique s'est formé.

Par ailleurs, le document de brevet EP 3492934 décrit un procédé de détection et de localisation d'un défaut affectant un câble électrique isolé basé sur la propagation d'onde acoustique dans le domaine des ultrasons, ceci le long du câble (propagation solidienne). De fait, ce type de dispositif présente l'inconvénient de nécessiter de nombreuses étapes de pré-caractérisation (vitesse du son à déterminer pour le type de câble). En outre, ce dispositif n'est pas efficace sur des grandes distances de par l'amortissement vibratoire élevé.

Il existe donc un besoin pour un dispositif de détection qui remédie, au moins en partie, aux inconvénients précités.

### Présentation générale

L'invention a pour objet un dispositif de détection acoustique d'un arc électrique. Ce dispositif comprend une sonde tubulaire adaptée pour être disposée à côté d'un matériel électrique au niveau duquel un arc électrique est susceptible de se former. Un espace intérieur, circonscrit par une paroi de la sonde, s'étend le long de la sonde. Cet espace intérieur, ou lumière, est rempli d'un fluide et isolé acoustiquement des bruits extérieurs par la paroi. La sonde comprend à la périphérie de son espace intérieur, au niveau de sa paroi, au moins une zone vulnérable adaptée pour se dégrader sous l'effet de l'arc électrique, en laissant apparaitre un passage vers l'espace intérieur pour une onde acoustique générée par l'arc électrique.

Le dispositif comprend, en outre, au moins un capteur acoustique adapté pour détecter l'onde acoustique ayant emprunté le passage et se propageant dans l'espace intérieur de la sonde.

La sonde tubulaire est creuse pour permettre à l'onde acoustique de se propager dans son espace intérieur avant d'atteindre le capteur acoustique.

La sonde peut s'étendre sur une distance significative, par exemple sur plusieurs mètres. L'onde acoustique se propageant à l'intérieur de la sonde, il est possible de détecter l'onde acoustique (et donc l'apparition de l'arc électrique) à une distance significative de l'emplacement où l'arc électrique se forme.

Un tel dispositif permet donc de détecter à distance l'apparition d'un arc électrique au niveau d'un matériel électrique. En particulier, le dispositif peut être utilisé pour détecter l'apparition d'un arc électrique le long d'un ou de plusieurs câbles électriques, auquel cas la sonde est disposée à côté et le long du ou des câbles électriques. Lorsque les câbles électriques sont assemblés en harnais, la sonde peut être intégrée au harnais.

Le fluide remplissant l'espace intérieur de la sonde peut être de l'air. L'air présente un avantage certain pour éviter les pertes et les fuites de fluide. Un autre fluide (gaz, liquide ou gel) pourrait toutefois être retenu à condition qu'il ne soit pas trop visqueux. En effet, moins le fluide est visqueux, plus l'onde acoustique peut se propager sur une grande distance. Il est également possible, de manière à augmenter la vitesse de détection, d'utiliser des fluides dans lesquels la vitesse de propagation de l'onde acoustique est plus importante que dans l'air. C'est le cas, notamment, de l'hélium et, de manière générale, de tout gaz ayant une constante spécifique de gaz parfait plus élevée que l'air.

Lorsque le fluide est un gaz, le capteur acoustique peut être un microphone.

La paroi de la sonde est de forme générale tubulaire. Cette paroi entoure l'espace intérieur de la sonde. Elle peut être monocouche ou multicouche.

La sonde présente, au niveau de cette paroi, une ou plusieurs zones vulnérables. Chaque zone vulnérable est adaptée pour se dégrader, au moins partiellement, sous l'effet de l'arc électrique, de manière à laisser apparaître un passage vers l'espace intérieur de la sonde. L'onde acoustique générée par l'arc électrique peut alors emprunter ce passage pour pénétrer dans l'espace intérieur de la sonde et s'y propager.

Dans certains modes de réalisation, ladite au moins une zone vulnérable est une zone fusible adaptée pour fondre, au moins partiellement, sous l'effet de la chaleur générée par l'arc électrique. Toutefois, des phénomènes de dégradation de la matière, autres que la fusion, comme des phénomènes de déformation ou de fissuration, peuvent être envisagés sans sortir du cadre de l'invention. Il suffit que la dégradation de la zone vulnérable, causée par l'arc électrique, conduise à l'apparition d'un passage pour l'onde acoustique vers l'espace intérieur de la sonde.

Lorsque la sonde présente une zone vulnérable, celle-ci peut s'étendre le long de la sonde. Par exemple, la zone vulnérable peut s'étendre parallèlement à l'axe de la sonde ou en spirale autour de cet axe. Lorsque la sonde présente une pluralité de zones vulnérables, celles-ci peuvent être reparties, régulièrement ou non, le long de la sonde.

Dans certains modes de réalisation, ladite au moins une zone fusible est formée par un film fusible qui recouvre une ouverture traversant la paroi. Un tel film, lorsqu'il est intact (i.e. non fondu), obture l'ouverture et contribue à isoler l'espace intérieur de la sonde contre les bruits extérieurs. En fondant sous l'effet de la chaleur générée par l'arc électrique, le film libère l'ouverture et l'onde acoustique générée par l'arc électrique peut alors emprunter l'ouverture pour rejoindre l'espace intérieur de la sonde et s'y propager.

Dans certains modes de réalisation, le film fusible a la faculté de se rétracter à la chaleur de sorte que le fim, en fondant, ne risque pas d'encombrer l'ouverture ou l'espace intérieur de la sonde. L'ouverture et l'espace intérieur de la sonde restent ainsi dégagés pour permettre la propagation de l'onde acoustique.

Dans certains modes de réalisation, le film fusible recouvre, extérieurement ou intérieurement, l'ensemble de la paroi. En d'autres termes, le film forme une chemise, intérieure ou extérieure, autour de la paroi de la sonde. Une telle configuration, entre autres avantages, simplifie la fabrication de la sonde tout en renforçant l'isolation contre les bruits extérieurs en dehors des zones vulnérables. Dans certains modes de réalisation, ladite au moins une zone vulnérable est formée par une zone d'épaisseur réduite de la paroi. Cette zone, du fait de son épaisseur réduite, est plus vulnérable que le reste de la paroi et se dégrade sous l'effet de l'arc électrique.

Lorsqu'un arc électrique se forme au niveau du matériel électrique, il dégrade la zone vulnérable et, du fait de cette dégradation, un passage vers l'espace intérieur se forme au niveau de cette zone. L'onde acoustique générée par l'arc électrique emprunte alors ce passage et se propage dans l'espace intérieur de la sonde jusqu'au capteur acoustique situé à distance de la zone vulnérable.

Le capteur acoustique peut être au contact de l'espace intérieur de la zone, c'est-à-dire en communication directe avec cet espace, ou communiquer indirectement avec cet espace via une liaison. Par exemple, dans certains modes de réalisation, un tuyau s'étend à travers la paroi depuis l'espace intérieur de la sonde jusqu'au capteur acoustique. L'onde acoustique passe alors par l'espace intérieur puis par le tuyau avant d'atteindre le capteur acoustique. Ceci permet de positionner le capteur acoustique à distance de la sonde. Cette configuration présente un avantage, par exemple, lorsque la sonde est intégrée à un harnais de câbles. Le capteur acoustique peut alors être positionné à la périphérie du harnais ou à l'extérieur de celui-ci. Afin de faciliter le positionnement du capteur, le tuyau peut être souple.

Dans certains modes de réalisation, le capteur acoustique est adapté pour détecter une onde acoustique dont la fréquence est inférieure à 1000 Hz et, en particulier, inférieure à 500 Hz. Les ondes acoustiques de basse fréquence sont privilégiées car l'atténuation de l'amplitude d'une onde, lorsqu'elle se propage dans l'espace intérieur de la sonde, est d'autant plus faible que sa fréquence est basse. Dans certains modes de réalisation, la section de l'espace intérieur de la sonde est suffisamment importante pour que l'atténuation acoustique le long de la sonde soit inférieure à 2 dB/m pour une onde de fréquence comprise entre 100 Hz et 500 Hz. Ceci permet de positionner le capteur acoustique à une distance significative de la zone vulnérable. Par exemple, la distance entre le capteur acoustique et la zone vulnérable (i.e. la zone la plus éloignée du capteur s'il existe plusieurs zones vulnérables) peut être de plusieurs mètres, voire une dizaine de mètres ou plus. Cette distance peut, notamment, être supérieure à deux mètres (2 m) et, plus particulièrement, être supérieure à cinq mètres (5 m).

Dans certains modes de réalisation, le dispositif comprend, en outre, une unité de calcul configurée pour déterminer, à partir du signal de mesure du ou des capteurs acoustiques, le temps de propagation de l'onde acoustique depuis la zone vulnérable dégradée jusqu'au(x) capteur(s) acoustique(s) et pour en déduire la localisation de l'arc électrique. Lorsque le dispositif est utilisé pour un câble électrique, ceci permet de localiser l'endroit, le long du câble électrique, où l'arc électrique s'est formé.

L'invention a également pour objet un ensemble comprenant un dispositif de détection tel que précédemment décrit et un harnais composé de plusieurs câbles électriques, dans lequel la sonde est intégrée au harnais et disposée le long des câbles électriques. En particulier, les câbles électriques du harnais peuvent être répartis circonférentiellement autour de la sonde.

Dans un tel ensemble, le dispositif de détection permet de détecter la formation d'un arc électrique au niveau de l'un quelconque des câbles.

Les caractéristiques et avantages de l'invention précédemment décrits, ainsi que d'autres, sont illustrés dans la description détaillée qui suit. Cette description détaillée fait référence aux dessins annexés.

### Brève description des dessins

Les dessins annexés sont schématiques et ne sont pas nécessairement à l'échelle, ils visent avant tout à illustrer les principes de l'invention. Sur ces dessins, d'une figure (fig) à l'autre, des éléments (ou parties d'élément) identiques sont repérés par les mêmes signes de référence.
[fig 1] Cette figure représente un exemple de harnais, en coupe transversale.
[fig 2] Cette figure représente le harnais de la figure 1 lors de la formation d'un arc électrique au niveau d'un des câbles électriques du harnais.
[fig 3] Cette figure représente, en coupe axiale, un exemple de dispositif de détection acoustique d'arc électrique.
[fig 4] Cette figure représente, en coupe axiale, un autre exemple de dispositif de détection acoustique d'arc électrique.
[fig 5] Cette figure représente le dispositif de la figure 4 lors de la formation d'un arc électrique.
[fig 6] Cette figure représente la propagation d'une onde acoustique générée par l'arc électrique dans le dispositif de la figure 5.
[fig 7] Cette figure représente, en vue de dessus selon la flèche VII, la sonde du dispositif de la figure 3 ou de la figure 4.
[fig 8] Cette figure représente la sonde de la figure 7 lors de la formation d'un arc électrique.
[fig 9] Cette figure représente l'atténuation acoustique théorique dans l'air au sein de tubes de différents diamètres intérieurs, en fonction de la fréquence de l'onde acoustique se propageant dans le tube.
[fig 10] Cette figure représente un autre exemple de dispositif de détection acoustique d'arc électrique.

### Description détaillée

Des modes de réalisation particuliers du dispositif de détection proposé sont décrits en détail ci-après, en référence aux exemples représentés sur les dessins annexés. Ces modes de réalisation illustrent les caractéristiques et les avantages de l'invention. Il est toutefois rappelé que l'invention ne se limite pas à ces modes de réalisation.

Dans ces modes de réalisation, le dispositif de détection comprend une sonde tubulaire 10 adaptée pour être disposée à côté d'un matériel électrique, en particulier un câble électrique 1. La sonde 10 est creuse, une paroi 4 de la sonde entourant et délimitant un espace intérieur 12. Cet espace intérieur 12 est rempli d'un fluide, en l'occurrence de l'air.

Dans les exemples représentés, en l'absence de contrainte mécanique externe, la sonde 10 a une forme générale de cylindre de révolution, d'axe X. La surface latérale, ou surface cylindrique, de la sonde 10 correspond à la face externe de paroi 4. L'espace intérieur 12 de la sonde, ou lumière de la sonde, s'étend le long de l'axe X. L'espace intérieur 12 a un diamètre D1 correspondant au diamètre intérieur de la sonde 10. La sonde 10 peut être suffisamment souple pour pouvoir être courbée, auquel cas l'axe X devient curviligne.

La sonde 10 comprend à la périphérie de son espace intérieur 12, au niveau de la paroi 4, des zones vulnérables 15 reparties le long de la sonde. Les zones vulnérables 15 peuvent être réparties régulièrement selon un écartement E.

Le dispositif comprend, en outre, au moins un capteur acoustique, en l'occurrence un microphone 7 à membrane vibrante, connecté à l'espace intérieur 12 via un tuyau 6.

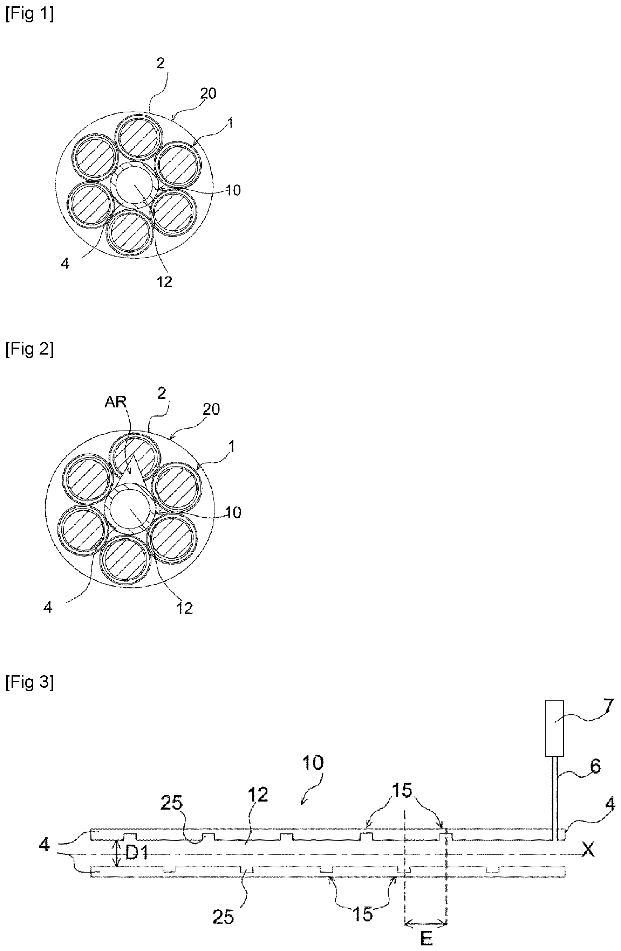

La figure 1 est une vue en coupe d'un exemple de harnais 20 composé de plusieurs câbles électriques 1. Ces câbles sont regroupés en faisceau au sein d'une enveloppe 2. La sonde 10 est intégrée au centre du harnais 20 et les câbles électriques 1 sont répartis circonférentiellement autour de la sonde 10. Les câbles 1 sont au contact ou à faible distance de la sonde 10.

La figure 2 est une vue en coupe, identique à la figure 1, illustrant la formation d'un arc électrique AR au niveau d'un des câbles électriques 1. L'arc électrique AR est représenté schématiquement par un cône. L'arc électrique AR émet un champ thermique intense mais local. Par exemple, pour un arc électrique de plus de 50 ampères (A), la température peut atteindre plus de 700°C et le gradient thermique peut être de 500°C/mm, depuis l'arc. La sonde 10 étant à proximité du câble électrique 1 au niveau duquel se forme l'arc électrique AR, la température à la surface de la sonde 10 peut atteindre plusieurs centaines de degrés (°C).

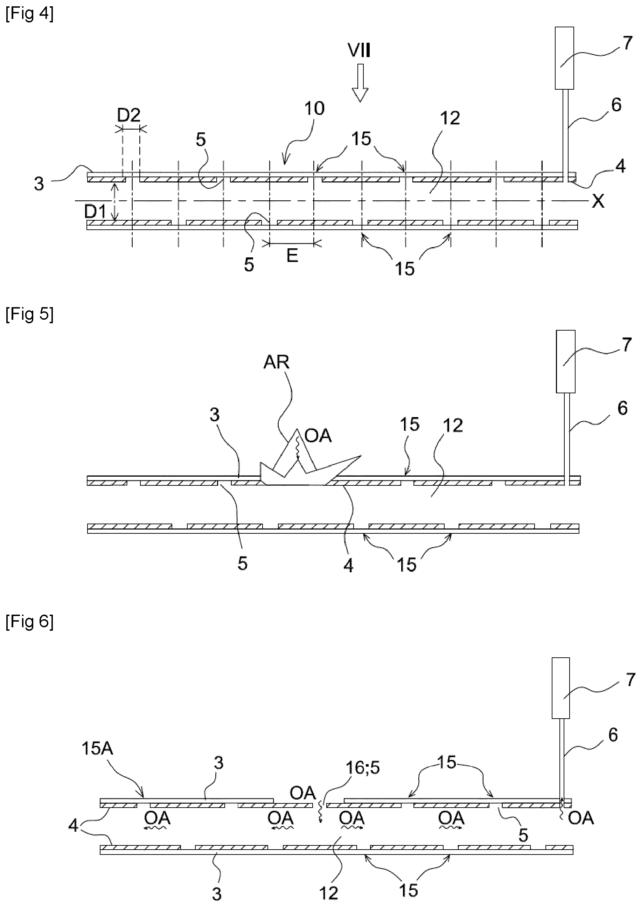

Les zones vulnérables 15 de la sonde 10 sont adaptées pour se dégrader sous l'effet de la chaleur générée par l'arc électrique AR, en laissant apparaitre un passage 16 vers l'espace intérieur 12 de la sonde. Une onde acoustique AO générée par l'arc électrique va alors emprunter ce passage 16 (voir l'exemple des figures 5 et 6).

Les zones vulnérables 15 de la sonde 10 peuvent être réalisées de différentes manières. Selon un exemple de réalisation (non représenté), la paroi 4 de la sonde 10 est faite de différents matériaux, plus ou moins résistants à la chaleur, dont au moins un matériau, le plus sensible à la chaleur, est susceptible d'être dégradé ou détruit par le champ thermique créé par l'arc électrique AR. Les zones vulnérables 15 sont réalisées en ce matériau sensible tandis que le reste de la paroi 4 est réalisé en au moins un matériau plus résistant à la chaleur.

Selon un autre exemple de réalisation, représenté sur la figure 3, la sonde 10 est homogène en composition et les zones vulnérables 15 sont des zones au niveau desquelles l'épaisseur de la paroi 4 est réduite. Cette réduction d'épaisseur se traduit par l'existence de creux, ou cavités 25, au niveau des zones vulnérables 15. Les cavités 25 peuvent être présentes sur la face interne de la paroi 4, comme illustré sur la figure 3. Les cavités 25 peuvent également être formées sur la face externe de la paroi 4, notamment pour des raisons pratiques de fabrication. Selon un autre exemple de réalisation, représenté sur les figures 4 à 6, la paroi 4 est perforée de façon répétée avec des trous 5 de diamètre D2, et est entourée par un film 3 non-perforé. En d'autres termes, le film 3 enveloppe extérieurement la paroi 4. Le film 3 est fusible, c'est-à-dire adapté pour fondre sous l'effet de la chaleur générée par l'arc électrique. La matière constitutive du film 3 a une température de fusion inférieure à la température émise par l'arc électrique AR, tandis que la matière constitutive de la paroi 4 a une température de fusion supérieure à la température émise par l'arc électrique AR.

La figure 5 illustre l'apparition d'un arc électrique AR à proximité de la sonde 10 et le rayonnement des ondes acoustiques OA générées par l'arc AR. La chaleur générée par l'arc AR provoque la fusion de la portion du film 3 la plus proche de l'arc et, ainsi, la mise à nu d'un des trous 5. Le trou 5 découvert forme alors un passage 16 vers l'espace intérieur 12 pour l'onde acoustique OA.

La fusion du film 3 ne doit pas conduire au remplissage du trou 5 car, dans ce cas, aucun passage 16 ne serait formé. Pour éviter cela, le film 3 est, par exemple, choisi suffisamment mince pour que la matière en fusion ne puisse pas combler le trou 5. En variante ou en complément, la matière constitutive du film 3 peut être choisie pour que le film 3 se rétracte sur lui-même lors de sa fusion.

La paroi 4 de la sonde peut être plus ou moins flexible en fonction de l'application envisagée. Par exemple, la paroi 4 est suffisamment flexible pour s'adapter à une configuration de harnais 20 donnée.

Par exemple, la paroi 4 peut être réalisée en polymère (e.g. élastomère, silicone, fluoropolymère) ou en métal. Le film 3 peut, quant à lui, être réalisé en acrylonitrile butadiène styrène (ABS), en polyoxyméthylène (POM), ou en polyéthylène (PE). Par exemple, un film 3 étirable en polyéthylène (dont la température de fusion est située entre 85 et 140°C) ayant une épaisseur entre 15 et 30 microns, peut être associé à une paroi 4 souple en silicone (dont le point de fusion est de l'ordre de 300°C), d'au moins 1 mm d'épaisseur. Selon un autre exemple, la paroi 4 peut être réalisée en polytétrafluoroéthylène (PTFE) (dont le point de fusion est de l'ordre de 330°C)
Après fusion du film 3 et détection de l'arc électrique AR, une bande ou un morceau de film 3 peut être déposé sur le trou 5 mis à nu pour le recouvrir, de manière à pouvoir réutiliser la sonde 10.

La figure 6 montre la transmission des ondes acoustiques OA à travers le passage 16 formé par le trou 5 mis à nu, la propagation de part et d'autre du trou 5 dans l'espace intérieur 12 et la propagation dans le tuyau 6 connecté au microphone 7. Dans l'exemple des figures, les trous 5 sont circulaires, disposés régulièrement suivant un espacement E selon l'axe X de la sonde 10 et alternativement de part et d'autre de la sonde 10 de manière à former deux rangées de trous diamétralement opposées (l'espacement entre deux trous adjacents d'une même rangée est donc le double de l'espacement E). Bien entendu, d'autres formes et d'autres distributions de trous, e.g. d'autres emplacements (angulaires) et d'autres espacements (non-réguliers) peuvent être envisagés sans sortir du cadre de l'invention. La distribution des trous 5 a une influence sur la précision de la localisation de l'arc AR. L'écartement E entre trous 5 doit permettre de mettre à jour un ou plusieurs trous lors de la fusion du film fusible 3. Par exemple, l'écartement E peut être millimétrique ou centimétrique et dépend du champ de température auquel est exposé le film. En particulier, l'écartement E entre trous 5 peut être compris entre 2 mm et 2 cm.

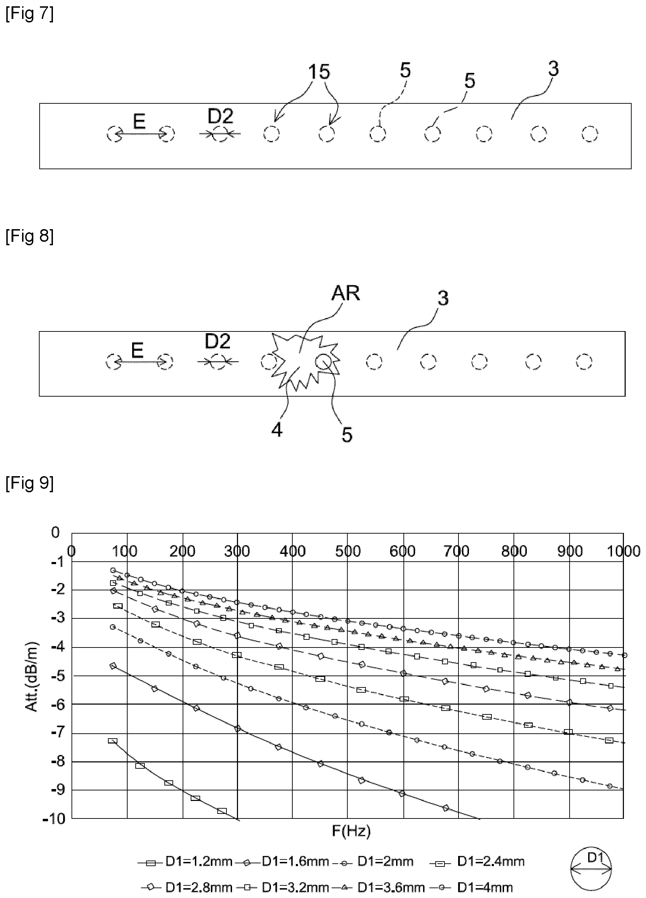

Le diamètre intérieur D1 de la sonde 10 est choisi de manière à limiter l'atténuation, de l'onde acoustique OA lors de sa propagation à l'intérieur de la sonde 10. La figure 9 représente l'atténuation acoustique théorique dans l'air, à température et pression ambiantes, au sein de tubes (assimilables à la sonde tubulaire 10) de différents diamètres intérieurs, en fonction de la fréquence de l'onde acoustique se propageant dans le tube. L'atténuation est notée "Att" et exprimée en décibels par mètre (dB/m). La fréquence est notée "F" et exprimée en hertz (Hz). Le diamètre intérieur du tube est noté "D1" et exprimé en millimètres (mm). L'atténuation est procurée par les pertes visco-thermiques dans la couche limite acoustique en périphérie de la surface interne du tube. Les phénomènes thermo-visqueux au sein d'un tube creux génèrent une résistance acoustique et, par là même, une atténuation d'amplitude des ondes propagées. Comme illustré, plus le diamètre intérieur D1 est élevé, plus l'atténuation acoustique est faible. Un diamètre D1 supérieur à 3,2 mm procure, par exemple, une atténuation acoustique légèrement inférieure à 2 dB/m à 100 Hz. Dans ce cas, pour une onde sonore de fréquence 100 Hz et pour une distance de propagation entre 1 et 10 m, l'atténuation d'amplitude varie entre 2 et 20 dB.

En pratique, le choix du diamètre D1 de la sonde 10 résulte d'un compromis entre le volume disponible pour la sonde (e.g. le volume disponible au sein d'un harnais dans laquelle la sonde est intégrée) et une atténuation acceptable au regard de la distance de propagation maximum envisagée pour l'onde acoustique OA. Par exemple, on peut choisir un couple diamètre / distance de propagation assurant une atténuation acoustique inférieure à 20 dB. La distance de propagation maximum envisagée est, par exemple, dans le dispositif de la figure 6, la distance entre le microphone 7 et la zone vulnérable 15A la plus éloignée du microphone 7. Par ailleurs, comme l'illustre la figure 9, pour un diamètre D1 donné, l'atténuation est d'autant plus importante que la fréquence de l'onde est élevée. Par conséquent, il peut être intéressant de privilégier la détection des ondes acoustiques de faible fréquence puisque ces ondes se propagent avec moins d'atténuation dans l'espace intérieur 12 de la sonde 10. Pour cette raison, le ou les microphones 7 utilisés peuvent être choisis, de préférence, pour détecter des ondes acoustiques de fréquence inférieure à 1000 Hz et, en particulier, inférieure à 500 Hz.

Le diamètre D2 des trous 5 est également choisi de manière à limiter l'atténuation de l'onde acoustique OA. Le choix de ce diamètre D2 peut, par ailleurs, être contraint par le diamètre D1 et par la technique de perforation choisie. En pratique, le diamètre D2 des trous 5 peut être millimétrique. Sur ce point, les inventeurs ont simulé le passage d'une onde ayant une fréquence de 200 Hz à travers un trou (assimilable au trou 5) de 1 mm de diamètre (assimilable au diamètre D2) ménagé dans la paroi d'un tube (assimilable à la sonde tubulaire 10) de 4 mm de diamètre intérieur (assimilable au diamètre D1). La simulation tenait compte des hypothèses d'excitation par monopole et des phénomènes thermo-visqueux dans le trou et le tube. Si une onde située à 1 mm de la paroi du tube produit une pression pariétale extérieure de l'ordre de 152 dB à la surface du trou, la pression à l'intérieur du tube est homogène et de l'ordre de 148 dB. L'atténuation de 4 dB produite par la traversée du trou et les effets thermo-visqueux associés est donc relativement faible et parfaitement acceptable compte-tenu du niveau d'émission acoustique de l'arc électrique et de la dynamique des microphones 7.

La propagation sans atténuation de l'onde acoustique OA dans l'espace intérieur 12 de la sonde 10 et la bonne détection de l'onde acoustique OA dépendent également de la bonne isolation acoustique de l'espace intérieur 12 contre les bruits extérieurs.

Dans l'exemple de la figure 3, l'isolation acoustique (dans les zones vulnérables 15 en dehors de ces zones 15) est assurée par la paroi 4. Dans l'exemple des figures 4 à 6, l'isolation acoustique est assurée par le film 3 dans les zones vulnérables 15 et par la paroi 4 en dehors de ces zones 15. A cet égard, on notera que la forme cylindrique de la paroi 4 et du film 3 favorisent grandement l'isolation acoustique procurée. En effet, la courbure de la paroi 4 et du film 3 fait apparaitre une fréquence, dite fréquence d'anneau, en deçà de laquelle l'indice d'affaiblissement acoustique augmente d'autant plus que la fréquence de l'onde acoustique est basse. Cette fréquence d'anneau est la fréquence pour laquelle la longueur d'onde longitudinale correspond au périmètre du cylindre. Ainsi, pour un tube de 4 mm de diamètre extérieur ayant une paroi en élastomère de 1 mm d'épaisseur et une fréquence d'anneau de l'ordre de 76000 Hz, l'indice d'affaiblissement acoustique théorique est supérieur à 90 dB pour une fréquence inférieure à 200 Hz. Par comparaison, pour une plaque (sans rayon de courbure) en élastomère de 1 mm d'épaisseur, l'indice d'affaiblissement acoustique théorique est seulement de l'ordre de 5 à 6 dB.

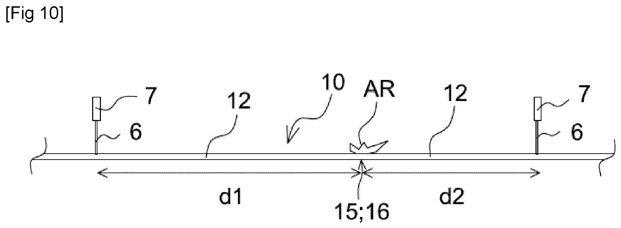

Une méthode de détection et de localisation d'un arc électrique va maintenant être décrite. En référence à la figure 10. Sur cette figure, le dispositif de détection comprend une sonde 10 comprenant des zones vulnérables 15 réparties le long de la sonde. Cette sonde 10 peut être semblable à la sonde de la figure 3 ou à celle de la figure 4. Le dispositif comprend, en outre, une série de microphones disposés de façon à ce que, a minima, deux microphones 71, 72, disposés de part et d'autre d'une zone vulnérable 15 affectée par un arc électrique AR détectent l'onde acoustique OA générée par cet arc et qui se propage à l'intérieur de la sonde 10. Par exemple, l'écartement entre deux microphones 71, 72, adjacents peut être métrique. Par exemple, cet écartement peut être compris entre 2 et 20 mètres et, plus particulièrement, entre 5 et 20 mètres.

Les extrémités ou terminaisons de la sonde 10 sont ouvertes vers l'extérieur ou équipées de bouchons qui absorbent les ondes acoustiques afin d'éviter un phénomène de réflexion des ondes acoustiques au niveau de ces extrémités (i.e. un phénomène d'écho).

Les ondes acoustiques OA se propagent de part et d'autre de la zone vulnérable 15 à la vitesse c et sont perçues par les deux microphones 71, 72 aux instants t1 et t2, respectivement. La distance séparant la zone vulnérable 15 du premier microphone 71 est notée d1 et la distance séparant la zone vulnérable 15 du deuxième microphone 72 est notée d2. Les ondes acoustiques OA sont perçues par les microphones 71, 72, avec un décalage temporel (t2 - t1) représentatif de la différence de distance parcourue. En l'espèce : $d 2 - d 1 = c \left(t2-t1\right)$

La distance L = d1 + d2 entre microphones étant prédéterminée, la position de l'arc électrique AR par rapport au microphone 71 peut alors être déduite aisément selon l'équation : $d 1 = \frac{\left(L-c\left(t2-t1\right)\right)}{2}$

Ce calcul est réalisé par une unité de calcul (non représentée) du dispositif recevant les signaux de mesure des microphone 71, 72.

Une telle méthode de localisation de l'arc électrique AR a l'avantage d'être fiable et relativement simple. Cependant, d'autres méthodes peuvent être envisagées pour localiser l'arc électrique à partir du signal de mesure du ou des capteurs acoustiques.

Par exemple, dans le cas où les terminaisons de la sonde 10 réfléchissent les ondes sonores, les signaux temporels en sortie du ou des capteurs acoustiques sont représentatifs d'une onde incidente et d'une onde rétro propagée par la terminaison la plus proche. Le décalage temporel entre la détection des ondes ainsi que les distances entre le ou les capteurs acoustiques et les terminaisons permettent alors de déterminer la position de l'arc.

Selon un autre exemple, il est possible de réaliser une analyse fréquentielle pour déduire la position de l'arc à l'aide d'un modèle de propagation acoustique d'ondes planes avec atténuation visco-thermique et le calcul des autospectres (SPL dB) des capteurs acoustiques.

Les modes de réalisation décrits dans le présent exposé sont donnés à titre illustratif et non limitatif, une personne du métier pouvant facilement, au vu de cet exposé, modifier ces modes de réalisation, ou en envisager d'autres, tout en restant dans le cadre de l'invention.

En particulier, une personne du métier pourra facilement envisager des variantes ne comprenant qu'une partie des caractéristiques des modes de réalisation précédemment décrits, si ces caractéristiques à elles seules suffisent pour procurer un des avantages de l'invention. De plus, les différentes caractéristiques de ces modes de réalisation peuvent être utilisées seules ou être combinées entre elles. Lorsqu'elles sont combinées, ces caractéristiques peuvent l'être comme décrit ci-dessus ou différemment, l'invention ne se limitant pas aux combinaisons spécifiques décrites dans le présent exposé. En particulier, sauf précision contraire, une caractéristique décrite en relation avec un mode de réalisation peut être appliquée de manière analogue à un autre mode de réalisation. L'invention est exposée dans le jeu de revendications joint.

## Revendications

1. Dispositif de détection acoustique d'un arc électrique, **caractérisé en ce qu'**il comprend une sonde (10) tubulaire adaptée pour être disposée à côté d'un matériel électrique au niveau duquel un arc électrique (AR) est susceptible de se former,
dans lequel un espace intérieur (12), circonscrit par une paroi (4) de la sonde, s'étend le long de la sonde (10), cet espace intérieur (12) étant rempli d'un fluide et isolé acoustiquement des bruits extérieurs par la paroi (4),
dans lequel la sonde (10) comprend à la périphérie de son espace intérieur (12), au niveau de sa paroi (4), au moins une zone vulnérable (15) adaptée pour se dégrader sous l'effet de l'arc électrique (AR), en laissant apparaitre un passage (16) vers l'espace intérieur pour une onde acoustique (OA) générée par l'arc électrique,
le dispositif comprenant, en outre, au moins un capteur acoustique (7, 71, 72) adapté pour détecter l'onde acoustique ayant emprunté le passage (16) et se propageant dans l'espace intérieur (12) de la sonde.

2. Dispositif selon la revendication 1, dans lequel ladite au moins une zone vulnérable (15) est une zone fusible adaptée pour fondre sous l'effet de la chaleur générée par l'arc électrique (AR).

3. Dispositif selon la revendication 2, dans lequel ladite zone fusible est formée par un film fusible (3) qui recouvre une ouverture (5) traversant la paroi.

4. Dispositif selon la revendication 3, dans lequel le film fusible (3) recouvre extérieurement ou intérieurement l'ensemble de la paroi (4).

5. Dispositif selon la revendication 3 ou 4, dans lequel le film fusible (3) a la faculté de se rétracter à la chaleur.

6. Dispositif selon la revendication 1 ou 2, dans lequel ladite au moins une zone vulnérable (15) est formée par une zone d'épaisseur réduite de la paroi (4).

7. Dispositif selon l'une quelconque des revendications 1 à 6, comprenant une pluralité de zones vulnérables (15) reparties le long de la sonde (10).

8. Dispositif selon l'une quelconque des revendications 1 à 7, dans lequel le fluide est de l'air.

9. Dispositif selon l'une quelconque des revendications 1 à 8, dans lequel un tuyau (6) s'étend à travers la paroi (4) depuis l'espace intérieur (12) de la sonde jusqu'au capteur acoustique (7, 71, 72).

10. Dispositif selon l'une quelconque des revendications 1 à 9, dans lequel le capteur acoustique (7, 71, 72) est adapté pour détecter une onde acoustique (OA) de fréquence inférieure à 1000 **Hz** et, en particulier, inférieure à 500 Hz.

11. Dispositif selon l'une quelconque des revendications 1 à 10, dans lequel la section de l'espace intérieur (12) de la sonde est suffisamment importante pour que l'atténuation acoustique le long de la sonde (10) soit inférieure à 2 dB/m pour une onde acoustique ayant une fréquence comprise entre 100 **Hz** et 500 Hz.

12. Dispositif selon l'une quelconque des revendications 1 à 11 comprenant, en outre, une unité de calcul configurée pour déterminer, à partir du signal de mesure dudit au moins un capteur acoustique (7, 71, 72), le temps de propagation de l'onde acoustique depuis la zone vulnérable (15) dégradée jusqu'au capteur acoustique et pour en déduire la localisation de l'arc électrique (AR).

13. Ensemble comprenant un dispositif selon l'une quelconque des revendications 1 à 12 et un harnais (20) composé de plusieurs câbles électriques (1), dans lequel la sonde (10) est intégrée au harnais et disposée le long des câbles électriques (1).

14. Ensemble selon la revendication 13, dans lequel les câbles électriques (1) sont répartis circonférentiellement autour de la sonde (10).

## Patentansprüche

1. Akustische Vorrichtung zur Erkennung eines Lichtbogens, **dadurch gekennzeichnet, dass** sie eine röhrenförmige Sonde (10) umfasst, die geeignet ist, neben einem elektrischen Gerät angeordnet zu sein, an dem sich ein Lichtbogen (AR) bilden kann,
wobei sich ein von einer Wand (4) der Sonde umgebener Innenraum (12) entlang der Sonde (10) erstreckt, wobei dieser Innenraum (12) mit einem Fluid gefüllt und durch die Wand (4) akustisch von Außengeräuschen isoliert ist, wobei die Sonde (10) an der Peripherie ihres Innenraums (12) an ihrer Wand (4) wenigstens einen empfindlichen Bereich (15) umfasst, der geeignet ist, sich unter der Wirkung des Lichtbogens (AR) zu zersetzen, wobei ein Durchgang (16) zum Innenraum für eine vom Lichtbogen erzeugte Schallwelle (OA) freigegeben wird,
wobei die Vorrichtung ferner mindestens einen akustischen Sensor (7, 71, 72) umfasst, der geeignet ist, die Schallwelle zu erkennen, die den Durchgang (16) durchquert hat und sich im Innenraum (12) der Sonde ausbreitet.

2. Vorrichtung nach Anspruch 1, wobei der wenigstens empfindliche Bereich (15) ein Schmelzbereich ist, der geeignet ist, unter der Wirkung der vom Lichtbogen (AR) erzeugten Wärme zu schmelzen.

3. Vorrichtung nach Anspruch 2, wobei der Schmelzbereich durch eine Schmelzfolie (3) gebildet ist, die eine durch die Wand hindurchgehende Öffnung (5) bedeckt.

4. Vorrichtung nach Anspruch 3, wobei die Schmelzfolie (3) die gesamte Wand (4) außen oder innen bedeckt.

5. Vorrichtung nach Anspruch 3 oder 4, wobei die Schmelzfolie (3) die Fähigkeit hat, bei Hitze zu schrumpfen.

6. Vorrichtung nach Anspruch 1 oder 2, wobei der wenigstens empfindliche Bereich (15) durch einen Bereich mit reduzierter Dicke der Wand (4) gebildet ist.

7. Vorrichtung nach einem der Ansprüche 1 bis 6, umfassend eine Vielzahl von empfindlichen Bereichen (15), die entlang der Sonde (10) verteilt sind.

8. Vorrichtung nach einem der Ansprüche 1 bis 7, wobei das Fluid Luft ist.

9. Vorrichtung nach einem der Ansprüche 1 bis 8, wobei sich ein Rohr (6) durch die Wand (4) vom Innenraum (12) der Sonde bis zum akustischen Sensor (7, 71, 72) erstreckt.

10. Vorrichtung nach einem der Ansprüche 1 bis 9, wobei der akustische Sensor (7, 71, 72) geeignet ist, eine Schallwelle (OA) mit einer Frequenz von weniger als 1000 Hz und insbesondere weniger als 500 Hz zu erkennen.

11. Vorrichtung nach einem der Ansprüche 1 bis 10, wobei der Querschnitt des Innenraums (12) der Sonde so groß ist, dass die Schalldämpfung entlang der Sonde (10) weniger als 2 dB/m für eine Schallwelle mit einer Frequenz zwischen 100 Hz und 500 Hz beträgt.

12. Vorrichtung nach einem der Ansprüche 1 bis 11, ferner umfassend eine Recheneinheit, die so eingerichtet ist, dass sie aus dem Messsignal des mindestens einen akustischen Sensors (7, 71, 72) die Ausbreitungszeit der Schallwelle vom empfindlichen Bereich (15) bis zum akustischen Sensor bestimmt und daraus die Lokalisierung des Lichtbogens (AR) ableitet.

13. Baugruppe, die eine Vorrichtung nach einem der Ansprüche 1 bis 12 und einen Kabelbaum (20) umfasst, der aus mehreren elektrischen Kabeln (1) besteht, wobei die Sonde (10) in den Kabelbaum integriert und entlang der elektrischen Kabel (1) angeordnet ist.

14. Baugruppe nach Anspruch 13, wobei die elektrischen Kabel (1) um die Sonde (10) herum verteilt sind.

## Claims

1. Device for the acoustic detection of an electric arc, **characterised in that** it comprises a tubular probe (10) adapted to be arranged beside an electrical equipment item at which an electric arc (AR) is liable to be formed, wherein an internal space (12) enclosed by a wall (4) of the probe extends along the probe (10), this internal space (12) being filled with a fluid and acoustically insulated from external noises by the wall (4),
wherein the probe (10) comprises on the periphery of its internal space (12), at its wall (4), at least one vulnerable zone (15) adapted to be degraded under the effect of the electric arc (AR) so as to provide a passage (16) towards the internal space for an acoustic wave (OA) generated by the electric arc,
the device further comprising at least one acoustic sensor (7, 71, 72) adapted to detect an acoustic wave that has travelled through the passage (16) and propagates in the internal space (12) of the probe.

2. Device according to claim 1, wherein said at least one vulnerable zone (15) is a fusible zone adapted to melt under the effect of the heat generated by the electric arc (AR).

3. Device according to claim 2, wherein said fusible zone is formed by a fusible film (3) which covers an opening (5) that extends through the wall.

4. Device according to claim 3, wherein the fusible film (3) externally or internally covers the entire wall (4).

5. Device according to claim 3 or 4, wherein the fusible film (3) is heat-shrinkable.

6. Device according to claim 1 or 2, wherein said at least one vulnerable zone (15) is formed by a zone of the wall (4) having a reduced thickness.

7. Device according to any one of claims 1 to 6, comprising a plurality of vulnerable zones (15) distributed along the probe (10).

8. Device according to any one of claims 1 to 7, wherein the fluid is air.

9. Device according to any one of claims 1 to 8, wherein a tube (6) extends through the wall (4) from the internal space (12) of the probe as far as the acoustic sensor (7, 71, 72).

10. Device according to any one of claims 1 to 9, wherein the acoustic sensor (7, 71, 72) is adapted to detect an acoustic wave (OA) having a frequency of less than 1000 Hz, in particular less than 500 Hz.

11. Device according to any one of claims 1 to 10, wherein the cross section of the internal space (12) of the probe is sufficiently large that the acoustic attenuation along the probe (10) is less than 2 dB/m for an acoustic wave having a frequency of between 100 Hz and 500 Hz.

12. Device according to any one of claims 1 to 11, further comprising a computation unit configured to determine, from the measurement signal of said at least one acoustic sensor (7, 71, 72), the propagation time of the acoustic wave from the degraded vulnerable zone (15) to acoustic sensor and to deduce the location of the electric arc (AR) therefrom.

13. Assembly comprising a device according to any one of claims 1 to 12 and a harness (20) comprising a plurality of electrical cables (1), wherein the probe (10) is integrated into the harness and is arranged along the electrical cables (1).

14. Assembly according to claim 13, wherein the electrical cables (1) are distributed circumferentially around the probe (10).
